# EUROPÄISCHE PATENTANMELDUNG

(11) **EP 4 694 626 A1**
(43) Veröffentlichungstag der Anmeldung: **11.02.2026**
(21) Anmeldenummer: 24193089.0
(22) Anmeldetag: 06.08.2024
(51) Int. Cl.: H10F 19/80, H10F 77/45, B32B 17/10

(54) **PHOTOLUMINESZENTE FOLIE, VERFAHREN ZUR HERSTELLUNG EINER PHOTOLUMINESZENTEN FOLIE, LUMINESZENTER SOLARKONZENTRATOR UND VERGLASUNGSBAUGRUPPE**

(71) Anmelder: Universität Kassel (Körperschaft d. öffentlichen Rechts), 34125 Kassel (DE)
(72) Erfinder: HARTUNG, Michael, 34212 Melsungen (DE); HEIM, Hans-Peter, 33332 Gütersloh (DE); KOCH, Matthias, 34127 Kassel (DE)
(74) Vertreter: Walther Bayer Faber Patentanwälte PartGmbB

(57) **Zusammenfassung**

Gegenstand der Erfindung ist eine photolumineszente Folie (1), gebildet aus einem Partikelverbundwerkstoff, der eine Matrixphase (11) und eine darin dispergierte Partikelphase (12) aufweist, wobei die Matrixphase (11) ein Polymer umfasst, und wobei die Partikelphase (12) photolumineszente Partikel, insbesondere Quantenpunkt-Nanostrukturen, umfasst.

## Beschreibung

Die Erfindung betrifft eine photolumineszente Folie, ein Verfahren zu deren Herstellung sowie einen Solarkonzentrator und eine

Verglasungsbaugruppe, die jeweils mit einer erfindungsgemäßen photolumineszenten Folie ausgestattet sind.

### STAND DER TECHNIK

Photolumineszenz ist ein physikalisches Phänomen, bei dem ein Material Licht emittiert, nachdem es durch die Absorption von Photonen angeregt wurde. In Abhängigkeit von der Dynamik der Emission wird zwischen Fluoreszenz und Phosphoreszenz unterschieden. Ein für technische Anwendungen wichtiges Phänomen bei der Photolumineszenz ist der sog. Stokes-Shift, der den Unterschied zwischen den Maxima von Absorptions- und Emissionsspektrum bezeichnet, d.h., einen Unterschied zwischen den Wellenlängen des absorbierten und des emittierten Lichts.

Photolumineszenz wird in lumineszenten Solarkonzentratoren (LSC) genutzt, um die Effizienz von Photovoltaikmodulen zu verbessern. Derartige Solarkonzentratoren weisen einen Lichtleitkörper, typischerweise aus Quarzglas oder einem Kunststoff, auf, in dem photolumineszente Partikel verteilt vorliegen oder dessen Oberfläche mit einer Funktionsschicht mit photolumineszenten Partikeln beschichtet ist. Das von den photolumineszenten Partikeln emittierte Lumineszenzlicht wird innerhalb des Lichtleitkörpers zu dessen Lichtauskopplungsflächen geführt, wo es zur Ausleuchtung von zweckmäßig angeordneten Photovoltaikmodulen genutzt wird. Die photolumineszenten Partikel können insbesondere zur Absorption des ultravioletten Anteils von direktem oder diffusem Sonnenlicht ausgebildet sein, wobei das emittierte Lumineszenzlicht vorzugsweise im Spektralbereich des nahen Infrarots liegt. Die photolumineszenten Partikel weisen somit vorteilhafterweise einen großen Stokes-Shift auf, wodurch insbesondere der unerwünschte Effekt der Selbstabsorption minimiert und die Transparenz des Systems im sichtbaren Spektrum nicht beeinträchtigt wird.

Lumineszente Solarkonzentratoren basierend auf Halbleiter-Nanostrukturen als photolumineszenten Partikeln sind beispielsweise in den Druckschriften US 2017/0218264 A1 und US 11,158,753 B2 offenbart.

### OFFENBARUNG DER ERFINDUNG

Es ist die Aufgabe der vorliegenden Erfindung, eine Weiterbildung eines photolumineszenten Funktionselements vorzuschlagen, welches insbesondere ein besondere Flexibilität hinsichtlich der damit funktionalisierbaren Bauteile und Anwendungen ermöglicht.

Diese Aufgabe wird gelöst von einer photolumineszenten Folie gemäß Anspruch 1 und einem Verfahren zu deren Herstellung gemäß Anspruch 5. Anwendungen der erfindungsgemäßen Folie in einem Solarkonzentrator und einer Verglasungsbaugruppe offenbaren die Ansprüche 8 und 9. Vorteilhafte Weiterbildungen der Erfindung sind in den abhängigen Ansprüchen angegeben.

Die Erfindung offenbart eine photolumineszente Folie, gebildet aus einem Partikelverbundwerkstoff, der eine Matrixphase und eine darin dispergierte Partikelphase aufweist, wobei die Matrixphase ein Polymer umfasst, und wobei die Partikelphase photolumineszente Partikel, insbesondere Quantenpunkt-Nanostrukturen, umfasst.

Der Grundgedanke der Erfindung besteht darin, die photolumineszente Funktion in einer Folie zu realisieren, welche zum Aufbringen auf unterschiedliche Lichtleitkörper geeignet ist. Dies erlaubt eine separate Herstellung und nachträgliche Applikation der funktionalisierten Folie, wodurch die im Stand der Technik gebräuchlichen Konzepte des Dotierens oder nasschemischen Beschichtens von Lichtleitkörpern ersetzt werden können. Das Folienkonzept auf Basis einer polymeren Matrixphase erlaubt vorteilhafterweise den Einsatz von etablierten Kunststoffverarbeitungsprozessen wie dem Compoundieren (Schmelzemischverfahren) und der Folienextrusion.

Beispielsweise umfasst die Matrixphase Polyethylen, Polyester, Polyvinylchlorid oder ein Polymer der Polyvinylacetal-Gruppe, insbesondere Polyvinylbutyral, welches einen besonders geeigneten Werkstoff darstellt. Polyvinylbutyral ist ein thermoplastisches Polymer, das beispielsweise als Zwischenfolie in Verbundsicherheitsgläsern eingesetzt wird. Es zeichnet sich durch eine hohe Transparenz im sichtbaren Lichtspektrum, zweckmäßige mechanische Flexibilität und Zähigkeit aus und weist eine starke Adhäsion auf diversen Werkstoffen, beispielsweise Quarzglas, auf. Zudem zeichnet sich Polyvinylbutyral durch seine gute Löslichkeit in organischen Lösemitteln und Kompatibilität mit weiteren Polymeren aus, sodass das Eindispergieren photolumineszenter Partikel unter Einsatz eines zweckmäßigen Trägermaterials prozesstechnisch gut handhabbar ist.

Die Partikelphase ist beispielsweise aus photolumineszenten Quantenpunkt-Nanostrukturen gebildet. Als Quantenpunkt-Nanostrukturen werden mesoskopische Systeme bezeichnet, deren elektronische Eigenschaften signifikant durch die Beschränkung ihrer räumlichen Abmessungen beeinflusst sind. Typische Strukturgrößen liegen im Bereich von 5 - 200 nm, wobei die räumliche Beschränkung strikt in 3 Raumdimensionen vorliegen kann oder auch nur in 2 Raumdimensionen, etwa bei Kohlenstoffnanoröhrchen.

Im Rahmen der vorliegenden Erfindung kann die Partikelphase prinzipiell jedwede Art von photolumineszenten Entitäten aufweisen, sofern diese zur Bildung eine Partikelverbundwerkstoffs mit einer polymeren Matrixphase sowie zur prozesstechnischen Verarbeitung als Folie geeignet sind. Typischerweise liegt deren größte Abmessung im Bereich von 50 nm - 1 µm ("Nanopartikel"). Dabei bildet die Partikelphase vorzugsweise einen Anteil von 0,5 - 5 Gew.% des Partikelverbundwerkstoffs, insbesondere 1 - 2 Gew.%. Zur Bildung der Partikelphase sind insbesondere kolloidale Halbleiter als Nanopartikel geeignet, beispielsweise partikelförmige Quantenpunkt-Nanostrukturen, etwa CuInS₂/ZnCuInS/ZnS mit Core-Shell-Shell-Struktur.

Die photolumineszente Folie weist beispielsweise eine Dicke von 10 - 200 µm auf. Die Dicke der Folie kann zweckmäßig an die adressierten Anwendungen sowie die detaillierten mechanischen und optischen Eigenschaften des die Folie konstituierenden Partikelverbundwerkstoffs angepasst werden.

Die Erfindung betrifft außerdem ein Verfahren zur Herstellung einer photolumineszenten Folie nach einer der vorgenannten Ausführungsformen, wenigstens umfassend die folgenden Schritte:
- Bereitstellen des Polymers für die Matrixphase, insbesondere in granularer Form,
- Bereitstellen eines Stoffgemischs für die Partikelphase, umfassend photolumineszente Partikel in einem Dispergiermittel,
- Compoundieren des Werkstoffs für die Matrixphase mit dem Stoffgemisch für die Partikelphase unter Bildung eines Granulats, und
- Extrudieren des Granulats und Formgebung in einer Folienanlage oder unter Verwendung eines Folienwerkzeugs unter Bildung der photolumineszenten Folie.

Das Compoundieren erfolgt insbesondere im Schmelzemischverfahren auf einem Mehrwellenextruder, in welchem dem polymeren Kunststoff für die Matrixphase das Stoffgemisch für die Partikelphase unter Wärme- und Schereinwirkung zugemischt wird. Nach dem Abkühlen der Schmelze werden die entstandenen Stränge granuliert, sodass ein photolumineszent funktionalisiertes Granulat bereitgestellt wird. Basierend auf diesem Granulat erfolgt die weitere Folienherstellung beispielsweise entweder mittels Direktextrusion aus einem Mehrschneckenextruder in eine Folienanlage oder mittels Einschneckenextruder mit angeschlossenem Folienwerkzeug. In der Folienanlage wird die Schmelze mittels einer Foliendüse (Breitschlitzdüse oder Blaskopfdüse) dünn extrudiert. Bei der Breitschlitzdüse wird dabei eine Abzugsanlage angeschlossen, um die Folie auf die gewünschte Dicke zu strecken; anschließend wird die Folie abgekühlt und aufgerollt. Bei der Blasfolienextrusion wird die Schmelze aufgeblasen und abgekühlt und die so gebildete Folie wird aufgeschnitten und aufgerollt.

Vorteilhafterweise weist das Dispergiermittel im Stoffgemisch für die Partikelphase ein Polymerwachs oder einen Weichmacher auf, beispielsweise 1,2-Cyclohexandicarbonsäurediisononylester (Markenname DINCH). Insbesondere bei Verwendung von Polyvinylbutyral als Polymer für die Matrixphase ergibt sich in der Kombination mit Polymerwachsen oder Weichmachern als Dispergiermittel für die photolumineszenten Partikel ein feindisperser und makroskopisch homogener Partikelverbundwerkstoff. Vorzugsweise bilden die photolumineszenten Partikel einen Anteil von 2 - 20 Gew.% des Stoffgemischs mit dem Dispergiermittel, insbesondere 5 - 10 Gew.%.

Die Erfindung betrifft zudem einen lumineszenten Solarkonzentrator, wenigstens umfassend einen Lichtleitkörper, eine auf einer Oberfläche des Solarkonzentrators angeordnete photolumineszente Folie nach einer der vorgenannten Ausführungsformen und ein an einer Lichtauskopplungsfläche des Solarkonzentrators angeordnetes Photovoltaikmodul. Aufgrund der erfindungsgemäßen Trennung von Lichtleitkörper und photolumineszenter Funktionalität durch Verwendung der Folie bestehen vorteilhafterweise besonders große Variationsmöglichkeiten hinsichtlich des Werkstoffs, der Geometrie, der Abmessungen und des Herstellungsverfahrens des Lichtleitkörpers. Dieser kann zunächst unabhängig konstruiert und gefertigt werden, wobei die photolumineszente Funktionalisierung des darauf basierenden Solarkonzentrators nachträglich durch Applikation der erfindungsgemäßen Folie erfolgt.

Die Erfindung betrifft weiterhin eine Verglasungsbaugruppe, insbesondere für eine Gebäudefassade, wenigstens umfassend eine Flachglasscheibe, eine auf einer Flachseite der Flachglasscheibe angeordnete photolumineszente Folie nach einer der vorgenannten Ausführungsformen und ein an einer Stirnseite der Flachglasscheibe angeordnetes Photovoltaikmodul. Die Verglasungsbaugruppe stellt somit ein Beispiel eines lumineszenten Solarkonzentrators dar, wobei auf die Verglasung eingestrahltes direktes oder diffuses Sonnenlicht anteilig zu Lumineszenzlicht konvertiert und zu den Stirnseiten der Flachglasscheibe geleitet wird. Die Flachglasscheibe ist beispielsweise aus gebräuchlichem Silikatglas ausgebildet und die photolumineszente Folie weist vorteilhafterweise ein Absorptionsmaximum im UV-Spektralbereich und ein Emissionsmaximum im nahen Infrarot auf, sodass die Folie die Durchsicht durch die Flachglasscheibe für einen menschlichen Betrachter nicht signifikant beeinträchtigt. Alternativ kann ein gewisser Abschattungs- oder Farbeffekt erwünscht sein und das Absorptionsspektrum der photolumineszenten Folie kann durch eine zweckmäßige Werkstoffauswahl dementsprechend ausgebildet sein.

In einer Ausführungsform als Mehrfachverglasung kann eine außenliegende, d.h., zum Sonnenlicht exponierte Flachglasscheibe aus einem Quarzglas ausgebildet sein, welches im Vergleich zu einem Silikatglas eine höhere Transmissivität für UV-Licht aufweist, sodass eine dahinter angeordnete photolumineszente Folie mit ausgeprägter UV-Absorption mit einer höheren Strahlungsleistung angeregt wird und somit auch stärker emittiert. Die nachfolgende innenliegende Flachglasscheibe kann vorzugsweise aus einem Silikatglas ausgebildet sein, um verbliebenes UV-Licht zu absorbieren.

In einer Ausführungsform ist die Verglasungsbaugruppe als eine Verbundsicherheitsverglasung ausgebildet, wobei die photolumineszente Folie zwischen zwei Flachglasscheiben unter Bildung eines Laminats angeordnet ist. Dabei stellt Polyvinylbutyral einen besonders geeigneten Kunststoff für die Matrixphase des Partikelverbundwerkstoffs der Folie dar und wird im Stand der Technik bereits als Schmelzklebstoff für Laminate in Verbundsicherheitsgläsern eingesetzt.

### Weiterhin kann die Verglasungsbaugruppe als eine

### Wärmeschutzverglasung ausgebildet sein, wobei die

Verglasungsbaugruppe wenigstens einen insbesondere mit einem Edelgas gefüllten Zwischenraum als Isolierzone aufweist. Insbesondere kann eine Kombination von Verbundsicherheits- und Wärmeschutzverglasung gebildet sein.

### AUSFÜHRUNGSBEISPIELE DER ERFINDUNG

Weitere, die Erfindung verbessernde Maßnahmen werden nachstehend gemeinsam mit der Beschreibung von Ausführungsbeispielen der Erfindung anhand der Figuren näher dargestellt. Es zeigt in schematischer Form:
- Fig. 1:: ein Detail einer erfindungsgemäßen Verglasungsbaugruppe,
- Fig. 2:: ein erstes Ausführungsbeispiel der erfindungsgemäßen Verglasungsbaugruppe,
- Fig. 3:: ein zweites Ausführungsbeispiel,
- Fig. 4:: ein drittes Ausführungsbeispiel, und
- Fig. 5:: ein viertes Ausführungsbeispiel.

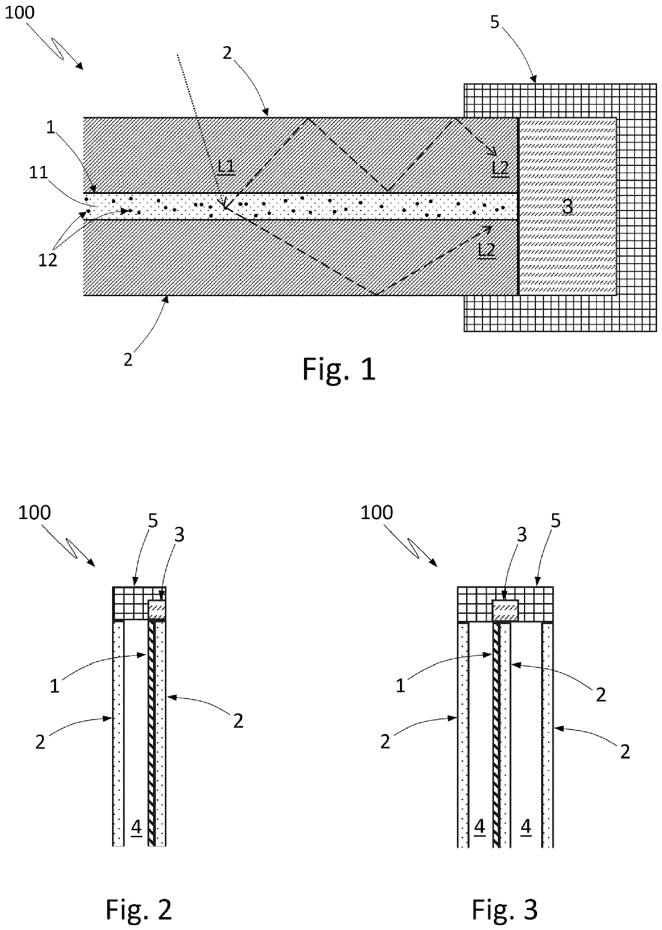

Fig. 1 zeigt eine Schnittansicht eines Details einer erfindungsgemäßen Verglasungsbaugruppe 100 umfassend zwei Flachglasscheiben 2, die ein Laminat mit der dazwischen angeordneten photolumineszenten Folie 1 bilden. Die Darstellung ist schematisch stark vereinfacht und in den relativen Abmessungen der dargestellten Komponenten nicht maßstabsgetreu. Insbesondere weist die photolumineszente Folie 1 eine Dicke von weniger als 200 µm auf, und die Flachglasscheiben 2 weisen eine Dicke von mehreren Millimetern auf.

Die photolumineszente Folie 1 ist aus einem Partikelverbundwerkstoff gebildet, der die Matrixphase 11 und die darin dispergierte Partikelphase 12 umfasst. Vorzugsweise umfasst die Matrixphase 11 Polyvinylbutyral und die Partikelphase 12 umfasst photolumineszente Partikel, insbesondere Quantenpunkt-Nanostrukturen.

Die Funktionsweise der Verglasungsbaugruppe 100 als lumineszenter Solarkonzentrator ist anhand beispielhafter Strahlengänge dargestellt: einfallendes Sonnenlicht L1, insbesondere aus dem UV-Spektralbereich, wird an einem photolumineszenten Partikel absorbiert, und anschließend erfolgt die Abregung des Partikels unter Emission von rotverschobenem Lumineszenzlicht L2. Das Lumineszenzlicht L2 tritt in die Flachglasscheiben 2 ein, die als Lichtleitkörper fungieren und das Lumineszenzlicht L2 per Totalreflexion an den Flachseiten in Richtung der Stirnseiten leiten. An den Stirnseiten der Flachglasscheiben 2 ist das (gänzlich schematisch dargestellte) Photovoltaikmodul 3 innerhalb des Rahmens 5 angeordnet, derart, dass es zum Betrieb mittels des aus den Flachglasscheiben 2 austretenden Lumineszenzlichts L2 eingerichtet ist.

Fig. 2 - 5 zeigen Schnittansichten von unterschiedlichen Ausführungsbeispielen der erfindungsgemäßen Verglasungsbaugruppe 100 als Mehrfachverglasungen, wiederum in rein schematischer Darstellung. Alle Ausführungsbeispiele stellen lumineszente Solarkonzentratoren dar und weisen im Rahmen 5 integrierte

Photovoltaikmodule 3 auf. Die photolumineszente Folie 1 ist jeweils auf der Flachseite von wenigstens einer Flachglasscheibe 2 angeordnet und die jeweilige Flachglasscheibe 2 fungiert als Lichtleitkörper für die Bestrahlung der stirnseitig angeordneten Photovoltaikmodule 3 mit Lumineszenzlicht. Insbesondere können die Photovoltaikmodule 3 im Wesentlichen vollumfänglich um die Stirnseiten der Flachglasscheiben 2 angeordnet sein. Beispielsweise kann die jeweils zum Sonnenlicht exponierte Flachglasscheibe 2 aus einem UV-transparenten Quarzglas ausgebildet sein, und die weiter innenliegenden Flachglasscheiben 2 sind aus einem Silikatglas gebildet.

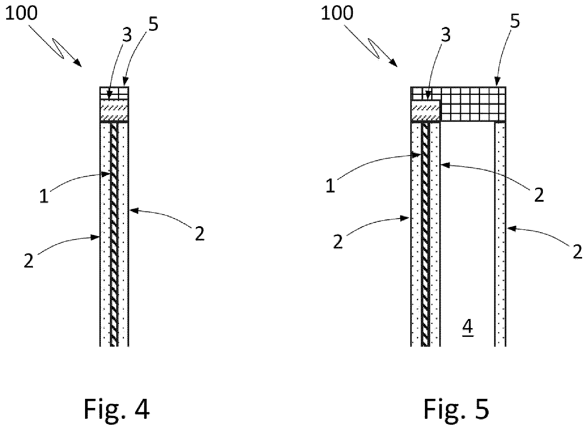

Fig. 2 und Fig. 3 zeigen Verglasungsbaugruppen ausgebildet als Wärmeschutzverglasung in Form einer Zweifach- bzw. Dreifachverglasung mit den der Wärmeisolation dienenden Zwischenräumen 4, die mit einem Edelgas gefüllt sind. Fig. 4 zeigt eine Verglasungsbaugruppe 100 ausgebildet als eine Verbundsicherheitsverglasung, wobei die photolumineszente Folie 1 zwischen zwei Flachglasscheiben 2 unter Bildung eines Laminats angeordnet ist. Fig. 5 zeigt eine Kombination aus Wärmeschutz- und Verbundsicherheitsverglasung.

### Bezugszeichenliste:

- 100: Verglasungsbaugruppe
- 1: Photolumineszente Folie
- 11: Matrixphase
- 12: Partikelphase
- 2: Flachglasscheibe
- 3: Photovoltaikmodul
- 4: Zwischenraum
- 5: Rahmen

- L1: Sonnenlicht
- L2: Lumineszenzlicht

## Patentansprüche

1. Photolumineszente Folie (1), gebildet aus einem
Partikelverbundwerkstoff, der eine Matrixphase (11) und eine darin dispergierte Partikelphase (12) aufweist, wobei die Matrixphase (11) ein Polymer umfasst, und wobei die Partikelphase (12) photolumineszente Partikel, insbesondere Quantenpunkt-Nanostrukturen, umfasst.

2. Folie (1) nach Anspruch 1,
**dadurch gekennzeichnet,**
**dass** die Matrixphase (11) Polyethylen, Polyester, Polyvinylchlorid oder ein Polymer der Polyvinylacetal-Gruppe, insbesondere Polyvinylbutyral, umfasst.

3. Folie (1) nach Anspruch 1 oder 2,
**dadurch gekennzeichnet,**
**dass** die Partikelphase (12) einen Anteil von 0,5 - 5 Gew.% des Partikelverbundwerkstoffs bildet, insbesondere 1 - 2 Gew.%.

4. Folie (1) nach einem der vorgenannten Ansprüche,
**dadurch gekennzeichnet,**
**dass** die Folie (1) eine Dicke von 10 - 200 µm aufweist.

5. Verfahren zur Herstellung einer photolumineszenten Folie (1) nach einem der vorgenannten Ansprüche, wenigstens umfassend die folgenden Schritte:
- Bereitstellen des Polymers für die Matrixphase (11), insbesondere in granularer Form,
- Bereitstellen eines Stoffgemischs für die Partikelphase (12), umfassend photolumineszente Partikel in einem Dispergiermittel,
- Compoundieren des Polymers für die Matrixphase (11) mit dem Stoffgemisch für die Partikelphase (12) unter Bildung eines Granulats, und
- Extrudieren des Granulats und Formgebung in einer Folienanlage oder unter Verwendung eines Folienwerkzeugs unter Bildung der photolumineszenten Folie (1).

6. Verfahren nach Anspruch 5,
**dadurch gekennzeichnet,**
**dass** das Dispergiermittel ein Polymerwachs oder einen Weichmacher aufweist.

7. Verfahren nach Anspruch 5 oder 6,
**dadurch gekennzeichnet,**
**dass** die photolumineszenten Partikel einen Anteil von 2 - 20 Gew.% des Stoffgemischs für die Partikelphase (12) bilden, insbesondere 5 - 10 Gew.%.

8. Lumineszenter Solarkonzentrator, wenigstens umfassend einen Lichtleitkörper, eine auf einer Oberfläche des Solarkonzentrators angeordnete photolumineszente Folie (1) nach einem der vorgenannten Ansprüche und ein an einer Lichtauskopplungsfläche des Solarkonzentrators angeordnetes Photovoltaikmodul.

9. Verglasungsbaugruppe (100), insbesondere für eine Gebäudefassade, wenigstens umfassend eine Flachglasscheibe (2), eine auf einer Flachseite der Flachglasscheibe (2) angeordnete photolumineszente Folie (1) nach einem der vorgenannten Ansprüche und ein an einer Stirnseite der Flachglasscheibe (2) angeordnetes Photovoltaikmodul (3).

10. Verglasungsbaugruppe (100) nach Anspruch 9, ausgebildet als eine Verbundsicherheitsverglasung, wobei die photolumineszente Folie (1) zwischen zwei Flachglasscheiben (2) unter Bildung eines Laminats angeordnet ist.

11. Verglasungsbaugruppe (100) nach Anspruch 9 oder 10, ausgebildet als eine Wärmeschutzverglasung, wobei die Verglasungsbaugruppe (100) wenigstens einen insbesondere mit einem Edelgas gefüllten Zwischenraum (4) aufweist.
